# EUROPEAN PATENT APPLICATION

(11) **EP 2 477 241 A2**
(43) Date of publication of application: **18.07.2012**
(21) Application number: 12150694.3
(22) Date of filing: 11.01.2012
(51) Int. Cl.: H01L 33/50

(54) **Method and Apparatus for Depositing Phosphor on Semiconductor Light-Emitting Device**

(30) Priority: 12.01.2011 KR 20110003152
(71) Applicant: Samsung LED Co., Ltd., Gyeonggi-do, 443-743 (KR)
(72) Inventor: Yoo, Cheol-jun, Chungcheongnam-do (KR); HONG, Seong-jae, Gyeonggi-do (KR)
(74) Representative: Grünecker, Kinkeldey, Stockmair & Schwanhäusser

(57) **Abstract**

A method and apparatus for depositing a phosphor via a compression molding process, the method involving forming a plurality of light-emitting devices on a wafer, evaluating emission characteristics of the plurality of light-emitting devices, and re-arraying and aligning the plurality of light-emitting devices on a carrier substrate according to the emission characteristics; depositing the phosphor on the plurality of re-arrayed light-emitting devices via a compression molding process; and dicing the plurality of re-arrayed light-emitting devices on the carrier substrate.

## Description

### BACKGROUND

### 1. Field

The present disclosure relates to methods and apparatuses for depositing a phosphor, and more particularly, to methods and apparatuses for depositing a phosphor by re-arraying manufactured light-emitting device chips according to their light-emitting characteristics and then by efficiently depositing the phosphor by using a compression molding method.

### 2. Description of the Related Art

A light-emitting diode (LED) is a semiconductor light-emitting device that converts an electrical signal into light, and is characterized in that the LED has a relatively long lifetime, compared to other light-emitting device, and may be driven at a low voltage. Recently, a lighting apparatus using a white LED having a high brightness replaces lighting apparatuses according to the related art. The white LED may be formed by depositing a phosphor having a red, green, or yellow color on a light-emitting device that emits green color light or ultraviolet (UV) light.

An example of a method of depositing a phosphor on a plurality of LED chips according to the related art is a wafer level coating method. The wafer level coating method involves forming a plurality of LED chips on a wafer and depositing a phosphor on the wafer before an optical characteristic of each LED chip is evaluated.

According to the wafer level coating method, the phosphor is deposited only on the wafer so that its application may be limited to an LED structure in which light is only emitted toward each LED chip.

Also, according to the wafer level coating method, before the plurality of LED chips are bin-sorted based on an optical characteristic evaluation for each of the plurality of LED chips, a phosphor paste is deposited on the wafer whereon the plurality of LED chips that are not bin-sorted are formed. Accordingly, due to an optical characteristic difference between the plurality of LED chips, white chips having irregular optical characteristics are formed, so that a yield rate in an entire process may sharply deteriorate.

### SUMMARY

Provided are methods of uniformly depositing a phosphor on a side surface and a top surface of each of light-emitting devices by performing compression molding on the light-emitting devices.

Provided are compression molding apparatuses capable of uniformly depositing a phosphor on a side surface and a top surface of each of light-emitting devices.

Additional aspects will be set forth in part in the description which follows and, in part, will be apparent from the description, or may be learned by practice of the presented embodiments.

According to an aspect of the present invention, a method of depositing a phosphor includes the operations of forming a plurality of light-emitting devices on a wafer, evaluating emission characteristics of the plurality of light-emitting devices, and re-arraying and aligning the plurality of light-emitting devices on a carrier substrate according to the emission characteristics; depositing the phosphor on the plurality of re-arrayed light-emitting devices via a compression molding process; and dicing the plurality of re-arrayed light-emitting devices on the carrier substrate.

The operation of evaluating the emission characteristics may include the operations of individually separating the plurality of light-emitting devices formed on the wafer, and evaluating the emission characteristic of each of the plurality of light-emitting devices.

The operation of evaluating the emission characteristics may include the operation of evaluating a light-emission wavelength, brightness, or a response time of each of the plurality of light-emitting devices.

The operation of re-arraying may include the operations of forming an adhesive layer on the carrier substrate, and then re-arraying light-emitting device chips having the same emission characteristic on the adhesive layer.

The adhesive layer may be formed of a photo-sensitive adhesive (PSA).

The operation of depositing the phosphor may include the operations of mounting the carrier substrate in a phosphor depositing apparatus, wherein the plurality of light-emitting devices are re-arrayed on the carrier substrate, and depositing the phosphor on the plurality of light-emitting devices by supplying the phosphor on a region of the carrier substrate, wherein the plurality of light-emitting devices are formed on the region.

The phosphor may be deposited on surfaces of each of the plurality of light-emitting devices, except for an electrode pad of each of the plurality of light-emitting devices.

According to another aspect of the present invention, a phosphor depositing apparatus includes an upper die in which a carrier substrate whereon a plurality of light-emitting devices are arrayed is mounted; a lower die formed to correspond to the upper die; and a molding die formed on a side surface of the lower die.

A pin connected to a spring of each of the plurality of light-emitting devices may be formed on the upper die.

A plurality of vacuum holes may be formed in the upper die.

A plurality of vacuum holes may be formed in the lower die.

A sealing rubber may be formed on the molding die so as to maintain an airtightness by contacting a release film adhered on the upper die, when a molding operation is performed.

The phosphor depositing apparatus may further include a release film contacting the upper die or the lower die.

The release film may be formed of polyvinyl chloride (PVC) or polyethylene terephthalate (PET).

A thickness of the release film may be in the range of several micrometers to several tens of micrometers.

### BRIEF DESCRIPTION OF THE DRAWINGS

These and/or other aspects will become apparent and more readily appreciated from the following description of the embodiments, taken in conjunction with the accompanying drawings of which:

FIG. 1 is a flowchart illustrating a process of forming a light-emitting device, which includes a compression molding method according to an embodiment of the present invention;

FIG. 2 illustrates a wafer and an array of light-emitting devices in a light-emitting device forming process;

FIG. 3 is a cross-sectional view illustrating a phosphor deposition process using compression molding, according to an embodiment of the present invention;

FIG. 4 is a cross-sectional view illustrating a phosphor deposition process using compression molding, according to another embodiment of the present invention;

FIGS. 5A and 5B illustrate an example of a light-emitting device whereon a phosphor is deposited via a compression molding process;

FIG. 6 illustrates a phosphor molding process using a compression molding apparatus, according to an embodiment of the present invention;

FIG. 7 illustrates a phosphor molding process using a compression molding apparatus, according to another embodiment of the present invention; and

FIG. 8 illustrates a process of depositing a phosphor by using a compression molding apparatus when a flip-chip is bonded to a printed circuit board (PCB), according to an embodiment of the present invention.

### DETAILED DESCRIPTION

Reference will now be made in detail to embodiments, examples of which are illustrated in the accompanying drawings. In the drawings, the thicknesses of layers and regions are exaggerated for clarity.

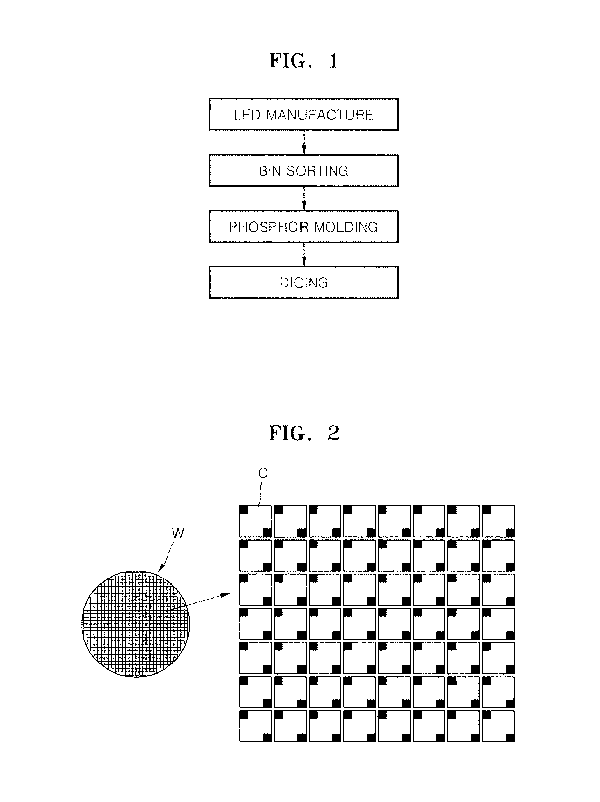

FIG. 1 is a flowchart illustrating a process of forming a light-emitting device, which includes a compression molding method according to an embodiment of the present invention. FIG. 2 illustrates a wafer and an array of light-emitting devices in a light-emitting device forming process.

Referring to FIGS. 1 and 2, a plurality of light-emitting devices, e.g., a plurality of light-emitting diode (LED) chips C are formed on a wafer W according to a semiconductor process. An LED chip forming process may indicate a general semiconductor LED forming process, and a plurality of LED chips C including electrode pads may be formed on one wafer W. A shape of each LED chip C is not limited, and in FIG. 2, the shape is rectangular. Each LED chip C may include an n-type electrode pad and a p-type electrode pad that are formed on its corner regions, respectively.

After the LED chips C are formed on the wafer W, the LED chips C are divided, a characteristic of each of the LED chips C is evaluated, and then the LED chips C are bin sorted according to their characteristics. The characteristics of the LED chips C may be bin-sorted based on a light-emission wavelength, brightness, or a response time, and may be random. For example, based on an emission wavelength of each of the LED chips C formed as illustrated in FIG. 2, only LED chips C having a specific emission wavelength band may be selectively bin-sorted. Hereinafter, in this specification, an LED chip's characteristic including a light-emission wavelength, brightness, or a response time may be referred to as an emission characteristic.

After the LED chips C are bin-sorted based on their emission characteristics, LED chips C included in the same group are re-arrayed and aligned on a carrier substrate, e.g., a sapphire substrate or the like. Hereafter, LED chips that are included in the same group according to a bin sort based on emission characteristics of the LED chips are referred to as LED chips having the same characteristic. An interval between the re-arrayed LED chips may be determined in consideration of a thickness of a phosphor to be deposited, and a process of depositing the phosphor and dicing the LED chips. For example, the LED chips may be disposed at an interval of several micrometers to several hundreds of micrometers. A number of pieces of LED chips to be re-arrayed and aligned on one carrier substrate is not limited, and may be random.

After the LED chips having the same characteristic are re-arrayed and aligned on the carrier substrate, a molding process of simultaneously depositing a phosphor on the LED chips is performed. In this manner, when LED chips having the same emission characteristic are aligned on one carrier substrate and then a phosphor is deposited thereon, it is easy to select a phosphor, and as a result, it is possible to control an emission characteristic of an LED package that is a final product, and to improve reliability of the LED package.

After performing the process of depositing the phosphor on the LED chips having the same characteristic, in order to form an LED chip package, a process of dicing the LED chips aligned on the carrier substrate may be performed. Here, in order to facilitate the dicing process, an interval between the LED chips aligned on the carrier substrate may be previously set, in consideration of the dicing process.

Hereinafter, a phosphor deposition process with respect to the LED chips re-arrayed and aligned on the carrier substrate, and a phosphor depositing apparatus used in the phosphor deposition process will be described in detail.

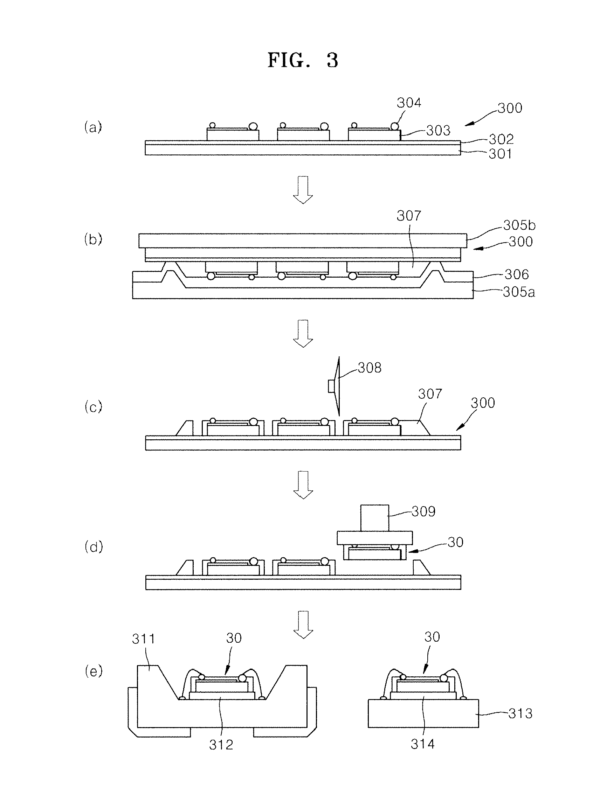

FIG. 3 is a cross-sectional view illustrating a phosphor deposition process using compression molding, according to an embodiment of the present invention.

Referring to (a) of FIG. 3, an adhesive layer 302 is formed on a carrier substrate 301, and a plurality of LED chips 303 are aligned on the adhesive layer 302. Here, the adhesive layer 302 is formed to fix the LED chips 303 on the carrier substrate 301. Hereinafter, the carrier substrate 301 having the LED chips 303 formed thereon is referred to as a carrier substrate 300.

The adhesive layer 302 may be formed of a photo-sensitive adhesive (PSA) and may be formed of a material capable of easily separating the LED chips 303 from the carrier substrate 301. An adhesive component of the adhesive layer 302 may be cured by irradiating ultraviolet (UV) light thereon. However, the adhesive layer 302 is optional, and if the carrier substrate 301 is formed of a material capable of easily fixing the LED chips 303, the adhesive layer 302 may be omitted. The carrier substrate 301 may be formed of a flexible material or a solid plate, and may be formed of one of organic and inorganic materials. Also, the carrier substrate 301 may be formed of a composite material formed by impregnating organic-based polymer or inorganic-based polymer with a glass fiber. The LED chips 303 may include electrode pads formed on their surfaces, and a bump 304 may be formed on each of the electrode pads of the LED chips 303. In the present embodiment, by using the carrier substrate 300 whereon the LED chips 303 are formed, a phosphor is deposited on side surfaces and top surfaces of the LED chips 303.

Referring to (b) of FIG. 3, the carrier substrate 300 whereon LED chips are formed is mounted in the phosphor depositing apparatus, and the phosphor is deposited on the carrier substrate 301.

Referring to (b) of FIG. 3, a release film 306 is adhered on a lower die 305a, and the carrier substrate 300 whereon LED chips are formed is fixed on an upper die 305b. After a phosphor paste 307 is supplied on the release film 306, the upper die 305b approaches the lower die 305a until the bumps 304 of the LED chips 303 contact the release film 306, and then the phosphor paste 307 is deposited on an exposed region of each LED chip 303 via a compression molding process.

The release film 306 may be adhered on a surface of the lower die 305a, and may be used to facilitate separation between a phosphor material and the lower die 305a after a phosphor deposition process. The release film 306 may be formed of a material such as polyvinyl chloride (PVC) or polyethylene terephthalate (PET). The phosphor paste 307 may be formed by mixing a resin and one or more phosphor materials according to a predetermined mixture ratio. The resin may include a material having high adherence, heat-resistance, low hygroscopicity, and high transmittance. For example, the resin may include a polymer material, an epoxy resin or a silicon-curable resin. Since the phosphor is cured in the lower die 305a and the upper die 305b, a thermocurable resin may be used. A content of the phosphor is not limited, and may be adjusted according to an optical characteristic of a light-emitting device, and a package level. For example, a weight ratio may be in the range of several percentage to several tens of percentage.

Referring to (c) and (d) of FIG. 3, the carrier substrate 300 whereon LED chips are formed is separated from the upper die 305b, and then LED chips on the carrier substrate 300 whereon LED chips are formed may be individually diced by using a cutter 308. Afterward, each LED chip 30 is separated from the adhesive layer 302 of the carrier substrate 301 by using a transporter 309.

The LED chips 30 that are separated may be formed as an LED package via an additional package process. As illustrated in (e) of FIG. 3, the LED package may be formed by fixing the carrier substrate 300 whereon the LED chips 30 are formed in chip mount portions 312 and 314 in package bodies 311 and 313, and by performing a wire bonding process.

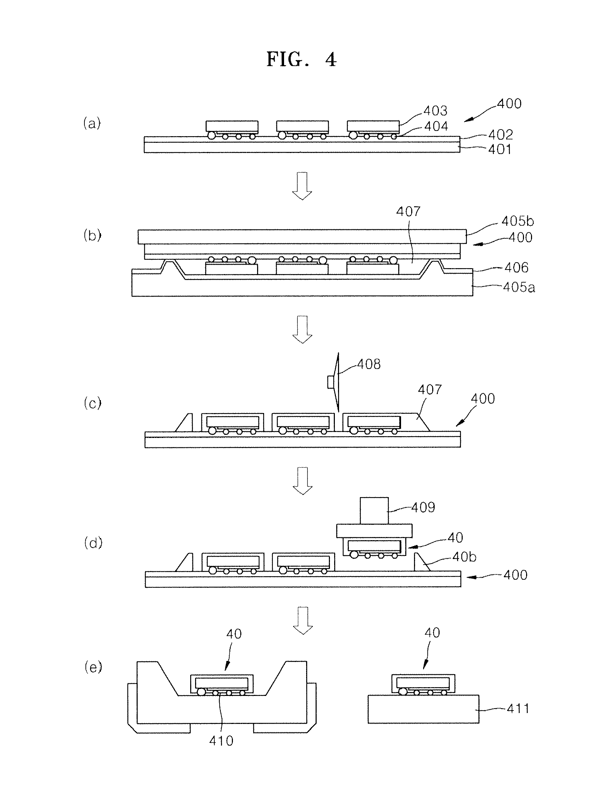

FIG. 4 is a cross-sectional view illustrating a phosphor deposition process using compression molding, according to another embodiment of the present invention. Unlike the previous embodiment of FIG. 3, in the present embodiment, a compression molding process is performed on an LED chip having a flip-chip structure.

Referring to (a) of FIG. 4, an adhesive layer 402 is formed on a carrier substrate 401, and a plurality of LED chips 403 are aligned on the adhesive layer 402. Here, the adhesive layer 402 is formed to fix the LED chips 403 on the carrier substrate 401. Bumps 404 may be formed on an electrode pad of each LED chip 403 and may be adhered in the adhesive layer 402. Since the LED chips 403 have a flip-chip structure, and a reflective layer is formed on an active layer of each LED chip 403, light may be emitted toward a top surface of a substrate and side surfaces of each LED chip 403 and the substrate, so that a phosphor may be deposited on a surface and a side surface of the substrate. The bumps 404 may be adhered without deformation, by using the adhesive layer 402, and may be buried in the adhesive layer 402 down to a predetermined depth. The adhesive layer 402 may have a thickness that is about 50% greater than a height of the bumps 404. In order to easily separate the bumps 404 from the adhesive layer 402, the adhesive layer 402 may be formed as a UV light curable adhesive formed of a PSA whose adherence is decreased after being cured.

A material of the adhesive layer 402 may include polyolefin, a photopolymerized acryl-based resin, or a composite material thereof. In a case where a molding temperature is relatively high, a polyimide-based photopolymerized material, an epoxy-based photopolymerized material, a silicone-based photopolymerized material, or a composite material thereof may be used so as to have heat-resistance.

Referring to (b) of FIG. 4, a carrier substrate whereon LED chips are formed 400 is mounted in a phosphor depositing apparatus, and the phosphor is deposited on the carrier substrate 401.

Referring to (b) of FIG. 4, a release film 406 is adhered on a lower die 405a, and the carrier substrate whereon LED chips are formed 400 is fixed on an upper die 405b. After a phosphor paste 407 is supplied on the release film 406, the upper die 405b approaches the lower die 405a until the phosphor is deposited on an exposed region of each LED chip 403, so that the phosphor paste 407 is deposited on the exposed region of each LED chip 403 via a compression molding process. The description about the release film 306 with reference to (b) of FIG. 3 may also be applied to the release film 406 in (b) of FIG. 4.

Referring to (c) and (d) of FIG. 4, the carrier substrate whereon LED chips are formed 400 is separated from the upper die 405b, and then LED chips 40 on the carrier substrate whereon LED chips are formed 400 may be individually diced by using a cutter 408. Afterward, each LED chip 40 whereon the phosphor is deposited is separated from the adhesive layer 402 of the carrier substrate 401 by using a transporter 409.

The LED chips 40 that are separated may be formed as an LED package via an additional package process. As illustrated in (e) of FIG. 4, the LED package may be formed by fixing the bumps 404 in package bodies 410 and 411, wherein the bumps 404 are of each LED chip 40 whereon the phosphor is deposited.

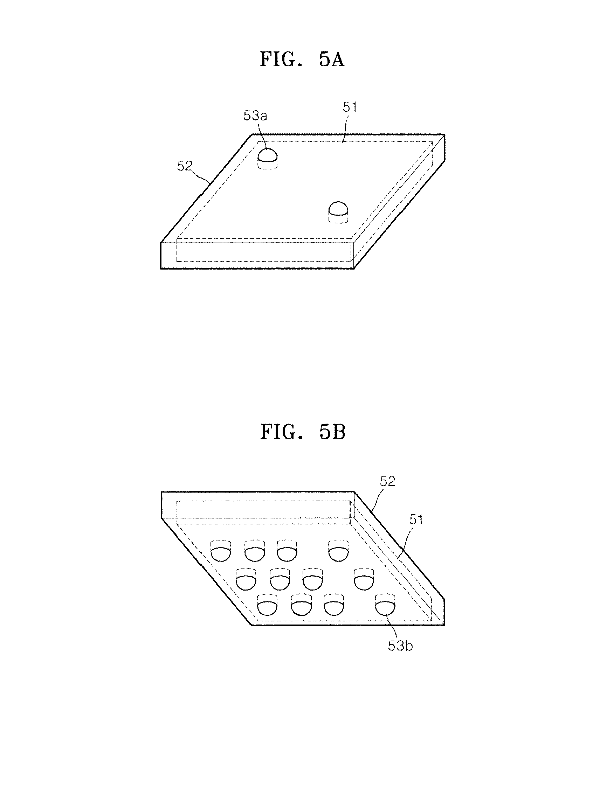

FIGS. 5A and 5B illustrate an example of a light-emitting device whereon a phosphor is deposited via a compression molding process. Referring to FIGS. 5A and 5B, the light-emitting device has a structure in which a chip surface 51 is molded by a phosphor 52, and bumps 53a and 53b that are connected to an electrode pad of the light-emitting device are projected from the phosphor 52.

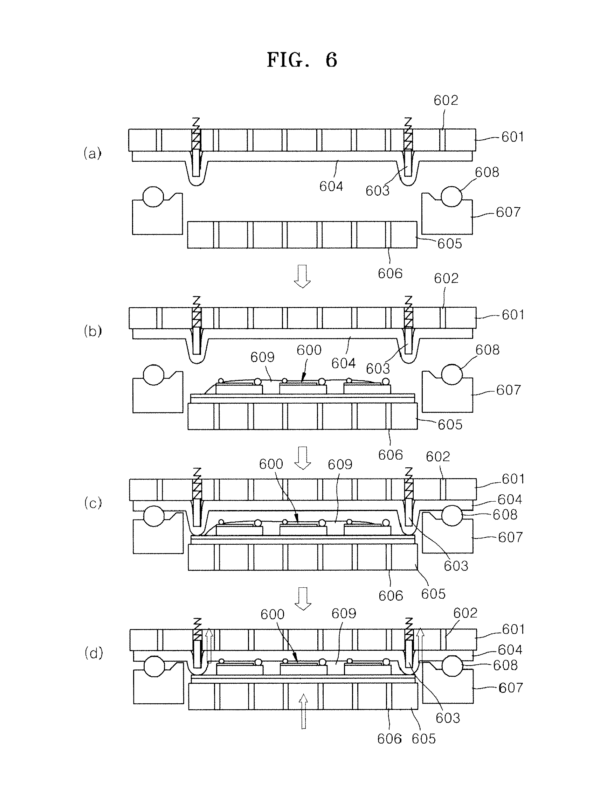

As described above, a method of depositing a phosphor according to one or more embodiments of the present invention may involve uniformly depositing the phosphor on a surface and a side surface of a light-emitting device, regardless of a shape of the light-emitting device, by performing compression molding. The compression molding according to one or more embodiments of the present invention may vary, and hereinafter, referring to FIGS. 6 through 10, a compression molding method and apparatus therefor will be described.

FIG. 6 illustrates a process of molding light-emitting devices that are re-arrayed on a carrier substrate so that their bumps face upward.

Referring to (a) of FIG. 6 illustrating the compression molding apparatus, a release film 604 is adhered on a surface of an upper die 601 by using a vacuum hole 602. A lower die 605 is positioned below the upper die 601, and has a vacuum hole 606. A molding die 607 is formed on a side surface of the lower die 605, and a sealing rubber 608 is formed on the molding die 607 so as to maintain an airtightness by contacting the release film 604 adhered on the upper die 601, when a molding operation is performed.

Referring to (b) of FIG. 6, a carrier substrate 600 whereon light-emitting devices, e.g., LED chips, are formed is mounted on the lower die 605, and the carrier substrate 600 whereon LED chips are formed is closely adhered to the lower die 605 while air is exhausted via the vacuum hole 606. Afterward, a phosphor paste 609 is dispensed on the carrier substrate 600 whereon LED chips are formed. Here, an amount of the dispensed phosphor paste 609 may be previously set, in consideration of a volume of a cavity that is an inner space of the dies 601, 605, and 607 when the upper die 601 and the lower die 605 are closely adhered to each other.

Referring to (c) of FIG. 6, when the upper die 601, or the lower die 605 and the molding die 607 move, the release film 604 on a pin 603 of the upper die 601 is closely adhered to the lower die 605. Here, air in the cavity is removed.

Referring to (d) of FIG. 6, compression molding is performed by applying a pressure to the carrier substrate 600 until a bump of the carrier substrate 600 whereon LED chips are formed contacts the release film 604. The bump is partly buried in the release film 604, and a phosphor having a predetermined thickness is deposited on a surface of each LED chip.

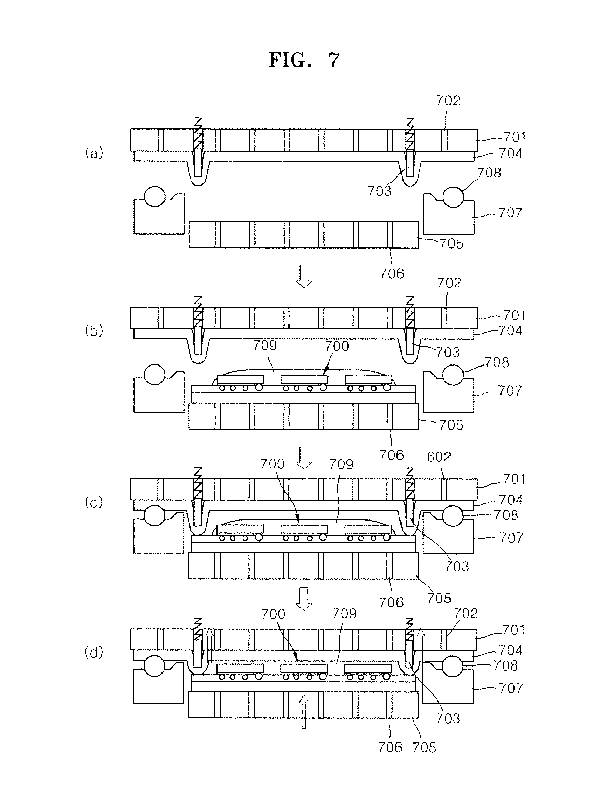

FIG. 7 illustrates a molding process of depositing a phosphor paste on a carrier substrate having an adhesive layer whereon a bump connected to an electrode pad of each LED chip is adhered thereto.

Referring to (a) of FIG. 7, a release film 704 is adhered on a surface of an upper die 701 by exhausting air via a vacuum hole 702. A lower die 705 is positioned below the upper die 701, and has a vacuum hole 706. A molding die 707 is formed on a side surface of the lower die 705, and a sealing rubber 708 is formed on the molding die 707 so as to maintain an airtightness by contacting the release film 704 adhered on the upper die 701, when a molding operation is performed.

Referring to (b) of FIG. 7, a carrier substrate 700 whereon LED chips are formed are mounted on the lower die 705, wherein the LED chips are re-arrayed so as to allow bumps formed on electrode pads of the LED chips to contact an adhesive layer, and the carrier substrate 700 whereon the LED chips are formed is closely adhered to the lower die 705 while air is exhausted via the vacuum hole 706 of the lower die 705. Afterward, a phosphor paste 709 is dispensed on the carrier substrate 700 whereon LED chips are formed.

Referring to (c) of FIG. 7, when the upper die 701, or the lower die 705 and the molding die 707 move, the release film 704 on a pin 703 of the upper die 701 is closely adhered to the lower die 705. In this process, air in a cavity that is a space between the upper die 701 and the lower die 705 is removed.

Referring to (d) of FIG. 7, compression molding is performed by applying a pressure to the carrier substrate 700 while the upper die 701 or the lower die 705 is moved upward or downward.

In the compression molding apparatuses of FIGS. 6 and 7, positions of the upper dies and the lower dies are relative, and thus the positions of the upper dies and the lower dies may be arbitrarily changed. In this case, the carrier substrate whereon LED chips are formed is mounted on the upper die, the release film is adhered on the lower die, and the phosphor paste may be dispensed on the release film on the lower die. Afterward, by performing a compression molding process while closely adhering the upper die and the lower die to each other, the phosphor paste may be deposited on an exposed region of each LED chip.

The method of depositing a phosphor by performing compression molding according to the one or more embodiments may be applied to not only a carrier substrate whereon light-emitting devices are re-arrayed but also applied to a case in which a light-emitting device chip is bonded to a printed circuit board (PCB).

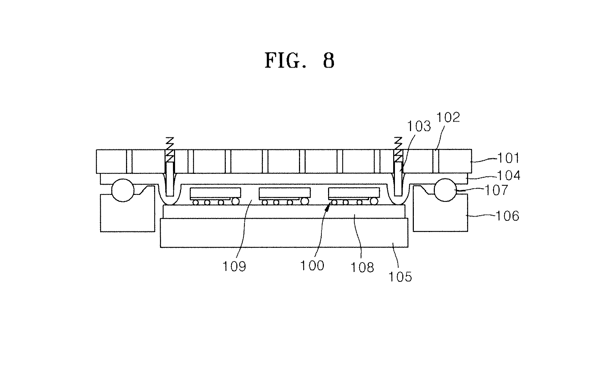

FIG. 8 illustrates a process of depositing a phosphor by performing compression molding, after a flip-chip is bonded to a PCB.

Referring to FIG. 8, an upper die 101 is prepared by adhering a release film 101 to a surface of the upper die 101 by removing air via a vacuum hole 102. A pin 103 connected to a spring is formed on the upper die 101. A lower die 105 is arranged below the upper die 101. A PCB 108, and light-emitting devices, e.g., LED chips 100 that are flip-chip boded to the PCB 108 are formed on the lower die 105.

A molding die 106 is formed on a side surface of the lower die 105, and a sealing rubber 107 is formed on the molding die 106 so as to maintain an airtightness by contacting the release film 104 of the upper die 101. While the upper die 101 and the lower die 105 are closely adhered to each other, a phosphor paste 109 may be deposited on exposed regions of the LED chips 100 that are flip-chip boded.

By performing a phosphor deposition process using compression molding, a phosphor may be easily deposited on a side surface and a top surface of each LED chip except for an electrode pad. Also, in a case of a flip-chip structure, a phosphor may be easily deposited around an emission surface. Since LED chips having similar emission characteristic are already re-arrayed, a phosphor paste may be easily selected according to the emission characteristic, so that a white LED having a reliable optical characteristic may be easily manufactured. By performing the method of depositing a phosphor according to the one or more embodiments of the present invention, it is possible to manufacture various LED packages, and to form a desired LED package by individually dicing LED chips on a carrier substrate.

According to the one or more embodiments of the present invention, the compression molding method may involve uniformly depositing a phosphor on top surfaces and side surfaces of light-emitting devices by re-arraying the light-emitting devices having a similar emission characteristic on a carrier substrate and then by depositing the phosphor via a compression molding process. By doing so, it is possible to provide white light-emitting devices having a uniform emission characteristic.

Also, according to the one or more embodiments of the present invention, it is possible to provide the compression molding apparatus capable of uniformly depositing the phosphor on the top surfaces and the side surfaces of the light-emitting devices.

It should be understood that the exemplary embodiments described therein should be considered in a descriptive sense only and not for purposes of limitation. Descriptions of features or aspects within each embodiment should typically be considered as available for other similar features or aspects in other embodiments.

## Claims

1. A method of depositing a phosphor, the method comprising:
forming a plurality of light-emitting devices on a wafer, evaluating emission characteristics of the plurality of light-emitting devices, and re-arraying and aligning the plurality of light-emitting devices on a carrier substrate according to the emission characteristics;
depositing the phosphor on the plurality of re-arrayed light-emitting devices via a compression molding process; and
dicing the plurality of re-arrayed light-emitting devices on the carrier substrate.

2. The method of claim 1, wherein the evaluating of the emission characteristics comprises individually separating the plurality of light-emitting devices formed on the wafer, and evaluating the emission characteristic of each of the plurality of light-emitting devices.

3. The method of claim 2, wherein the evaluating of the emission characteristics comprises evaluating a light-emission wavelength, brightness, or a response time of each of the plurality of light-emitting devices.

4. The method of claim 1, wherein the re-arraying comprises forming an adhesive layer on the carrier substrate, and then re-arraying light-emitting device chips having the same emission characteristic on the adhesive layer.

5. The method of claim 4, wherein the adhesive layer is formed of a photo-sensitive adhesive (PSA).

6. The method of claim 1, wherein the depositing of the phosphor comprises mounting the carrier substrate in a phosphor depositing apparatus, wherein the plurality of light-emitting devices are re-arrayed on the carrier substrate, and depositing the phosphor on the plurality of light-emitting devices by supplying the phosphor on a region of the carrier substrate, wherein the plurality of light-emitting devices are formed on the region.

7. The method of claim 6, wherein the phosphor is deposited on surfaces of each of the plurality of light-emitting devices, except for an electrode pad of each of the plurality of light-emitting devices.

8. A phosphor depositing apparatus comprising:
an upper die in which a carrier substrate whereon a plurality of light-emitting devices are arrayed is mounted;
a lower die formed to correspond to the upper die; and
a molding die formed on a side surface of the lower die.

9. The phosphor depositing apparatus of claim 8, wherein a pin connected to a spring of each of the plurality of light-emitting devices is formed on the upper die.

10. The phosphor depositing apparatus of claim 8, wherein a plurality of vacuum holes are formed in the upper die.

11. The phosphor depositing apparatus of claim 8, wherein a plurality of vacuum holes are formed in the lower die.

12. The phosphor depositing apparatus of claim 8, wherein a sealing rubber is formed on the molding die so as to maintain an airtightness by contacting a release film adhered on the upper die, when a molding operation is performed.

13. The phosphor depositing apparatus of claim 8, further comprising a release film contacting the upper die or the lower die.

14. The phosphor depositing apparatus of claim 13, wherein the release film is formed of polyvinyl chloride (PVC) or polyethylene terephthalate (PET).

15. The phosphor depositing apparatus of claim 13, wherein a thickness of the release film is in the range of several micrometers to several tens of micrometers.
